# EUROPEAN PATENT SPECIFICATION

(11) **EP 0 765 179 B1**
(45) Date of publication and mention of the grant of the patent: **05.01.2000**
(21) Application number: 95922835.4
(22) Date of filing: 08.06.1995
(51) Int. Cl.: A62C 3/16, H01L 23/18

(54) **FIRE PREVENTION DEVICE FOR ELECTRONICS**
FEUERSCHUTZVORRICHTUNG FÜR ELEKTRONIKA
DISPOSITIF ANTI-FEU POUR COMPOSANTS ELECTRONIQUES

(30) Priority: 14.06.1994 SE 9402083
(43) Date of publication of application: 02.04.1997
(73) Proprietor: TELEFONAKTIEBOLAGET LM ERICSSON, 126 25 Stockholm (SE)
(72) Inventor: LEEB, Karl-Erik, S-130 40 Djurhamn (SE)
(74) Representative: Norin, Klas
(86) International application number: SE9500689
(87) International publication number: WO9534347

(56) References cited:
- EP-A- 0 018 250
- WO-A-92/20096
- FI-B- 83 464
- FR-A- 2 518 812
- GB-A- 2 219 433
- US-A- 4 768 081
- PATENT ABSTRACTS OF JAPAN, Vol. 10, No. 179, E-414; & JP,A,61 027 663 (NEC CORP), 7 February 1986.
- PATENT ABSTRACTS OF JAPAN, Vol. 11, No. 77, E-487; & JP,A,61 231 742 (MITSUBISHI ELECTRIC CORP), 16 October 1986.

## Description

### TECHNICAL FIELD

The present invention relates to a device for preventing damage to electronic material by fire and therewith preventing the spreading of fire that could otherwise damage adjacent equipment and buildings.

### BACKGROUND ART

The electronic circuits are comprised of different components, such as integrated transistor networks, capacitors, electrical resistors and inductances. These components are mutually connected in the intended manner by means of a pattern of metal conductors which are normally mounted on a flat plastic board, a so-called printed circuit board. The circuits are also often mutually connected by means of electrical cables provided with insulating plastic or rubber casings. The above-mentioned components are most often encapsulated in plastic, to impart a controllable form to said components and to protect them from a harmful ambient environment.

Electric current passing through components, printed circuit boards and cables often varies in value, wherewith the electrical energy is converted to thermal energy. Since the elements often consist in metal conductors that are in direct connection with organic polymers, there is a danger of the organic materials being heated to their ignition temperatures and being ignited, with the consequent risk of fire spreading from the ignited area. The circuits are constructed primarily to prevent the occurrence of such overheating, although faults in the components can result in unexpected electrical imbalances which give rise to electric currents that are many times higher than the currents for which the circuitry is designed, these imbalances being capable of resulting in the development of extremely high temperatures that are able to ignite adjacent organic material. Other causes of fire include inductive circuits or high unexpected increases in the electrical resistance of conductor paths or in joins between different conductor paths, which can give rise to the conversion of energy to thermal energy over a more concentrated area than that for which the construction was originally intended. Because electronic systems are often expensive and because operational disturbances can often have very serious consequences, such as the spreading of fire in the surroundings, for instance in buildings, there is a very strong argument to support the prevention of fire. At present, this problem is resolved by admixing or synthesizing all delimiting organic material in components, printed circuit boards and cabling for instance with substances that have a fire-suffocating effect.

One group of substances used in this regard are organic bromo-compounds or compounds that contain other halogens. Fire-generated bromo-compounds of low molecular weight have a very pronounced fire-suffocating effect. One very common example in this respect is the use of brominated epoxy resins, which constitutes a monomer in the manufacture of epoxy plastics used in semi-conductor capsules and epoxy-based printed circuit boards. One problem with this solution, however, is that when manufacturing the monomer, ie the brominated epoxy resin, bromide ion residues are likely to remain, or low molecular-weight bromo-compounds that can later be hydrolyzed to form bromide ions, resulting in marked disturbances in the electrical function and in pronounced electrolytic corrosion as a result of ion conduction via the bromide ions. This problem is solved by special purification measures taken in conjunction with the organic synthesis process. This solution makes the material very expensive, however. Another problem associated with the fabrication of brominated epoxy resins resides in the high viscosity and melting point of the compounds, which makes it difficult to handle the resin mixture when, e.g., impregnating fibre glass fabrics, such fabrics being a semi-manufacture in the production of circuit board laminates. A third problem, which has recently been given more attention, resides in the long term effects that halogenated organic substances have on the environment when introduced into the ecosphere. Halogenated organic substances have three different effects on the environment:
a) Halogens present in the stratosphere convert ozone to oxygen gas, therewith decreasing ozone concentration. The use of freons has been prohibited because of this. Freons contain the halogens fluorine and chlorine. Bromine is a halogen which in this context has a more pronounced ability to convert ozone to oxygen gas. A decrease in the ozone layer results in an increase in the radiation of harmful ultraviolet light onto the earth's surface.
b) When heated, organic halogen compounds, including bromo-compounds, are the precursors of dioxins, which are highly toxic.
c) Low molecular-weight halogen compounds are effective in absorbing thermal radiation within a wavelength range lying within the same range as the wavelength range of heat from the earth into space. Furthermore, a large part of the absorption spectrum of these halogen compounds lies within a range that is not absorbed by carbon dioxide, which is now considered to be the dominant greenhouse gas, and the dangerous fact is that halogen compounds are able to overshadow the spectral window of the carbon dioxide. Consequently, relatively small amounts of halogen compounds have a relatively large influence on the heating of the lower atmosphere.

The consequences of these three different influences on the environment are difficult to assess in quantitative terms. An overview of these consequences are described by Georg Witt in "Strålning och atmosfären - processer på gott och ont" published in Natural Science Research Counsel's yearbook of 1987 and by Christoffer Rappe in "Environmental Impact of Brominated Flame Retardants" published in Plastic and Rubber Institute 92:133-148.

Plastic material included as a dielectric in electric circuits and containing halogenated flame retardants, and then particularly bromine, are admittedly relatively stable and are not decomposed under normal operating conditions. It is possible that small concentrations are released in the production of the semi-manufacture. The serious and not-readily assessed danger to the environment resides in the fact that when used in electrical circuits these materials are liable to decompose in scrapped circuits, for instance by composting or by combustion. Whether it be earlier or later these materials will nevertheless decompose, and the combined large and increasing quantity of electronic scrap therefore constitutes a serious latent problem.

Other flame-retardant agents are known, although the use of these often lowers the properties of the insulating material.

The aforedescribed methods greatly limit the selectiveness of components in plastic formulations, making it impossible to obtain the best conceivable electrical properties, such as high dielectric strength, a low relative dielectric constant and a low loss factor, which also constitutes a problem.

### SUMMARY OF THE INVENTION

The present invention relates to a device for preventing fire in electronics and the object of the invention is to solve the problems associated with the use of state of the art techniques.

The device has the form of a casing which encloses the electronic circuit and a volume of gas or liquid that surrounds said circuit, the oxygen content of said gas or liquid volume being so low as to be unable to sustain the combustion of organic material. The casing enclosing said gas or liquid volume is comprised of a material which is so impervious to gas diffusion as to prevent the oxygen content from rising to a concentration sufficiently high to sustain combustion as a result of oxygen diffusing from the ambient air, this diffusion impermeability remaining during the useful lifetime of the electronics. The joins in the casing are also correspondingly impervious to the diffusion of oxygen.

The device solves the aforementioned problems associated with established techniques. The components, circuit boards and cables may be insulated with material which is both cheaper, possesses better technical properties than earlier used insulating materials and may be totally innocuous from an environmental aspect.

The invention will now be described in more detail with reference to exemplifying embodiments thereof and also with reference to the accompanying drawing.

### BRIEF DESCRIPTION OF THE DRAWING

Figure 1 is a cross-sectional view of one embodiment of the device.
Figure 2 is an enlarged cross-sectional view of part of a second embodiment of the inventive device.

### BEST MODES OF CARRYING OUT THE INVENTION

A number of different embodiments are described below with reference to the accompanying drawing. The described embodiments can vary in different ways, and it will be understood that the invention is solely limited by the contents of the following Claims.

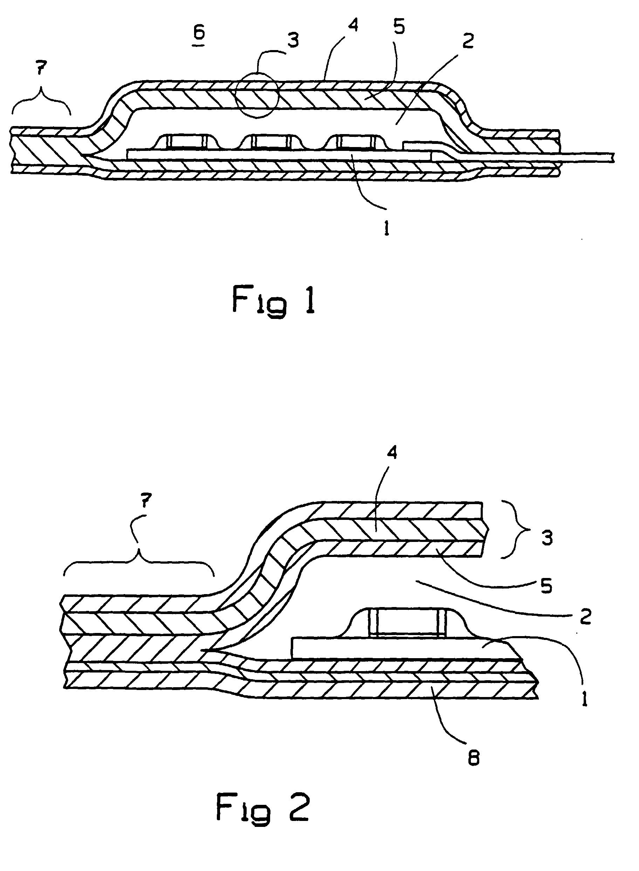

Figure 1 illustrates an electronic circuit 1 and a circuit-surrounding gas volume 2 enclosed by a casing 3. The casing 3 is comprised of a laminate which includes a metal foil 4 that lies proximal to the ambient air 6, and a thermoplastic sheet 5 which lies proximal to the enclosed gas volume 2. The metal foil or sheet 4 and the thermoplastic sheet or layer 5 adhere effectively one to the other. The laminate from which the casing 3 is formed is fusion-welded so as to form a joint between the thermoplastic layers 5 on the inner surface of the laminate 3, therewith sealing the casing 3 at joints 7. The oxygen-gas concentration of the gas volume 2 which encloses the electronic circuit 1, either completely or partially, is so low as to prevent the organic materials included in the electronic circuit 1 or the thermoplastic layer 5 of the casing 3 from igniting even should a fault in the circuit 1 lead to uncontrolled and pronounced overheating of the circuit. As a result of the metal foil 4 in the casing 3, air is unable to diffuse from the ambient air 6 into the gas volume 2 between the electronic circuit 1 and the casing 3 in an amount which would raise the oxygen concentration to a level at which the material would ignite or a level at which fire could be sustained in the event of overheating, this prevention being effective during the lifetime of the electronics. The gas imperviousness can be improved further by using a laminate which includes several layers of metal foil 4 and intermediate plastic layers 5. The jointing zones are relatively broad at the joins 7 and hence the diffusion path is relatively long in comparison with the area at right angles to the diffusion direction when oxygen-gas diffuses from the ambient air 6 into the gas volume 2 within the casing 3. Consequently, the amount of air able to diffuse through the joints is also insufficient to increase the oxygen concentration to a level at which there is a danger of ignition in the event of overheating, this preventative state of the device prevailing during the lifetime of the electronics. In the event of a fire in the surroundings, the outer metal-foil covering of the casing 3 is sufficient to prevent ignition for a reasonable length of time.

According to one variant of the described embodiment, the volume 2 surrounding the electric circuit 1 and enclosed by the casing 3 is filled, either completely or partially, with an insulating liquid which functions to facilitate the transportation of heat during normal working of the circuit 1 and to assist in maintaining a constant capsule volume in the occurrence of variations in pressure and temperature. In the case of this variant, the oxygen concentration in the volume 2 may not be so high as to cause oxygen-gas precipitation as a result of heating and as a result of reduced solubility at the elevated temperature, to an extent such that the amount of oxygen gas present is able to sustain fire.

In the case of the embodiment illustrated in Figure 2, the electronic circuit 1 is surrounded by an oxygen-free gas volume 2 and the casing 3 is comprised of a metal foil 4 and a plastic layer 5 suitable for fusion-welding of the substrate layers to form the joints 7. There is provided on top of the metal foil 4 a covering of plastic material 8 which in combination with the thermally conductive metal foil 4 is unable to sustain fire. Examples of such plastic material 8 are silicone elastomers which when burning in oxygen form a suffocating outer layer of silicon dioxide. The outer plastic material 8 may also include aluminium hydroxide, Al₂O₃ · 3H₂O, as a filler which acts as an extinguishing agent by splitting water when heated. Because aluminium oxide impairs electrical properties, it cannot be used in immediate contact with the electronics 1 and is therefore isolated from the electronics 1 and the surrounding gas volume 2 by the metal foil 4.

In accordance with an alternative variant, the volume 2 is filled either completely or partially with a solid material, for instance a plastic material, that is able to fulfil the same objects and requirements as those fulfilled with the liquid volume 2.

It will be understood that the invention is not restricted to the aforedescribed and illustrated embodiments thereof and that modifications can be made within the scope of the following Claims.

## Claims

1. A device for preventing the occurrence of fire in electronics, the electronics being in the form of a substrate-mounted circuit, the device including a casing (3) which is impervious to diffusion and which encloses the electronic circuit (1) and a volume (2) surrounding said circuit, the volume (2) including a medium having a low oxygen-gas concentration, and the outer side (8) of the casing (3) being made of a material which is non-combustible in air, **characterized** in that the casing (3) is comprised of a laminate which includes a plastic layer and one or more metal layers or one or more layers of silica.

2. A device according to Claim 1, **characterized** in that the medium in the volume (2) between the electronic circuit (1) and the casing (3) is a gas volume.

3. A device according to Claim 1, **characterized** in that the medium in the volume (2) between the electronic circuit (1) and the casing (3) is a liquid volume.

4. A device according to Claim 1, **characterized** in that the medium in the volume (2) between the electronic circuit (1) and the casing (3) is a solid substance volume.

## Patentansprüche

1. Einrichtung zum Verhindern des Auftretens von Feuer in Elektronika, wobei die Elektronika in der Form einer auf einem Substrat angebrachten Schaltung sind, wobei die Einrichtung ein Gehäuse (3) umfaßt, das für eine Diffusion undurchlässig ist und das die elektrische Schaltung (1) und ein Volumen (2), das die Schaltung umgibt, einschließt, wobei das Volumen (2) ein Medium mit einer niedrigen Sauerstoffgaskonzentration umfaßt, und wobei die äußere Seite (8) des Gehäuses (3) aus einem Material gebildet ist, welches in der Luft nichtverbrennbar ist, dadurch gekennzeichnet, daß das Gehäuse (3) aus einem Laminat besteht, das eine Plastikschicht und eine oder mehrere Metallschichten auf einer oder mehreren Schichten von Silika umfaßt.

2. Einrichtung nach Anspruch 1, dadurch gekennzeichnet, daß das Medium in dem Volumen (2) zwischen der elektrischen Schaltung (1) und dem Gehäuse (3) ein Gasvolumen ist.

3. Einrichtung nach Anspruch 1, dadurch gekennzeichnet, daß das Medium in dem Volumen (2) zwischen der elektrischen Schaltung (1) und dem Gehäuse (3) ein flüssiges Volumen ist.

4. Einrichtung nach Anspruch 1, dadurch gekennzeichnet, daß das Medium in dem Volumen (2) zwischen der elektrischen Schaltung (1) und dem Gehäuse (3) ein Festsubstanzvolumen ist.

## Revendications

1. Dispositif pour empêcher l'apparition d'un incendie dans les composants électroniques, les composants électroniques étant sous forme d'un circuit monté sur un substrat, le dispositif comprenant un boîtier (3) qui est imperméable à la diffusion et qui englobe le circuit électronique (1) et un volume (2) entourant ledit circuit, le volume (2) comprenant un milieu ayant une faible concentration d'oxygène gazeux, et la face extérieure (8) du boîtier (3) étant constituée d'une matière qui est non combustible dans l'air, caractérisé en ce que le boîtier (3) est constitué d'un stratifié qui comprend une couche de matière plastique et une ou plusieurs couches métalliques ou bien une ou plusieurs couches de silice.

2. Dispositif suivant la revendication 1, caractérisé en ce que le milieu dans le volume (2) entre le circuit électronique (1) et le boîtier (3) consiste en un volume de gaz.

3. Dispositif suivant la revendication 1, caractérisé en ce que le milieu dans le volume (2) entre le circuit électronique (1) et le boîtier (3) consiste en un volume de liquide.

4. Dispositif suivant la revendication 1, caractérisé en ce que le milieu dans le volume (2) entre le circuit électronique (1) et le boîtier (3) consiste en un volume d'une substance solide.
